# EUROPEAN PATENT APPLICATION

(11) **EP 4 557 543 A1**
(43) Date of publication of application: **21.05.2025**
(21) Application number: 24212826.2
(22) Date of filing: 13.11.2024
(51) Int. Cl.: H02H 3/08, H02H 7/26, G01R 15/14, G01R 19/00, G01R 19/165, H02H 3/087

(54) **LOAD-BREAK SWITCHING DEVICE, SWITCHING CABINET, AUTOMATION SYSTEM AND METHOD FOR OPERATING A LOAD-BREAK SWITCHING DEVICE**

(30) Priority: 13.11.2023 EP 23209561
(71) Applicant: Future Systems Besitz GmbH, 96472 Rödental (DE)
(72) Inventor: Först, Bernhard, 96317 Kronach (DE); Masel, Joram, 96328 Küps (DE)
(74) Representative: Bratovic, Nino Maria

(57) **Abstract**

The invention relates to a small-sized load-break switching device for a busbar system. The load-break switching device comprises shunt resistors which are arranged close to the connection to the busbar system. A voltage drop over the shunt resistors is analysed to determine a current value flowing through the load-break switching device.

## Description

The present invention relates to a load-break switching device, in particular a load-break switching device for a busbar system. Present invention further relates to a switching cabinet arrangement and an automation system with a load-break switching device. Further, the present invention relates to a method for operating a load-break switching device.

### Background

Switching devices, in particular switch disconnectors, may be used in an industrial environment for switching a power supply to a load, e.g., to an electrical device. Switch disconnectors are designed to interrupt an electrical connection even if an electrical current is flowing through the switch.

During the operation of a system with such a switch disconnector, it is often desirable to measure and monitor the currents flowing through the switch disconnector. For example, a current measurement might be useful for capturing electricity consumption of electrical systems, building units and individual consumers such as motors. Especially, the measured current may serve as a basis for billing of the consumed electricity. Further, the monitoring of the current can be used for detecting changes in electricity consumption, e.g. for predictive maintenance. The monitored current may be also used for recognising critical states of the device itself and the connected consumers. However, previously known approaches, such as Rogowski coils, current transformers or hall sensors, are relatively complex and expensive or need a large installation space. Further, these approaches are also very sensitive to interference, which requires further measures in order to protect the sensing elements against external disturbances.

In view of this, it is desirable to have a solution for a simple and reliable concept for measuring electric currents in a switch disconnector that need only a small installation space. In particular, there is a need for switch disconnectors which can realise current measurements by means of small-sized and preferably low-cost elements. Further, there is a need for current measurements in switch disconnectors which is robust against interferences.

### Summary

The present invention therefore takes into account the above needs and provides a load-break switch device, a method for operating a load-break switch device, a switching cabinet arrangement and an automation system with the features of the independent claims. Further advantageous embodiments are subject matter of the dependent claims.

According to a first aspect, a load-break switching device is provided. The load-break switching device comprises a first connector unit, a second connector unit, a load-break unit and at least one shunt resistor. The first connector unit comprises at least one first terminal. In particular a separate first terminal may be provided for each terminal of a power source or load which shall be connected to the first connector unit. For example, the first connection unit may comprise separate first terminal for each busbar of a busbar system. Accordingly, each first terminal may be adapted to be connected to one busbar of the busbar system.

The second connector unit comprises at least one second terminal. In particular, the number of second terminals may correspond to the number of first terminals. In particular, each second terminal is adapted to be connected to an electrical connection of an external electrical device. The external electrical device may be, for example, an electrical load such as a motor or the like. However, it may be also possible that the electrical device is a power source, e.g. an inverter of a regenerative energy system or the like.

The load-break unit is adapted to interrupt the electrical connections between the first terminals of the first connector unit and the corresponding second terminals of the second connector unit. In particular, the load-break unit is adapted to interrupt the electrical connection even if a current is flowing through the load-break unit.

One shunt resistor is arranged in each current path between a first terminal of the first connector unit and a second terminal of the second connector unit. In particular, the shunt resistors are arranged between the first connector unit and the load-break unit. In other words, the shunt resistors are arranged electrically close to the first terminals of the first connection unit.

Further, a fuse unit is disposed in a current path between each first terminal of the first connector unit and the corresponding second terminal of the second connector unit.

According to a second aspect, a switching cabinet arrangement is provided. The switching cabinet arrangement comprises a busbar system and a load-break switching device according to the first aspect. In particular, the busbar system comprises at least one busbar electrically connected to the first connector unit of the load-break switching device. The busbar system is adapted to be connected to a power source. For example, the power source may be an inverter, e.g. an inverter of a regenerative energy system such as a photovoltaic device. Additionally or alternatively, the busbar system may be connected to a power sink. For example, the busbar system may receive electric energy from a power source connected to the second connector unit und provide the energy to a grid, a battery, etc.

According to a third aspect, an automation system is provided. The automation system comprises a busbar system, an electrical device and a load-break switching device, in particular a load-break switching device according to the first aspect. The busbar system is adapted to be connected to a power source. Additionally or alternatively, the load-break switching device may be connected to a power source. For example, the power source may be an inverter, e.g. an inverter of a regenerative energy system such as a photovoltaic device. The electrical device of the automation system is electrically connected to the load break switching device. In particular, the electrical device may be connected to the second connector unit of the load-break switching device.

According to a further aspect, a method for operating a load-break switching device, in particular load-break switching device according to the first aspect is provided. The method comprises a step of measuring a voltage drop over the shunt resistor, in particular a voltage drop over the shunt resistor in the current path between one of the first terminals of the first connector unit and the load-break unit. Further, the method comprises a step of determining a current in the respective current path between one of the first terminals of the first connector unit and the load-break unit. The current is a determined based on the measured voltage drop over the respective shunt resistor. Further, the method comprises a step of providing an output signal indicating the determined current.

The present invention is based on the finding that currently known concepts for current measuring in switch disconnectors require rather complex hardware elements such as current transformers, hall sensors or Rogowski coils. Since such existing concepts are relatively sensitive to interferences, especially interfering a magnetic field, these solutions require additional measures for protecting the current sensing elements against such disturbances. These additional measures as well as the relatively large volume of the sensor itself require a large assembly volume for current sensing devices in a switch disconnector.

The present invention therefore takes into account this finding and aims to provide an improved load-break switching device with current sensing capabilities. In particular, the present invention aims to provide a load-break switching device with current sensing capabilities which can be realised with reduced assembly volume and which can provide a current measurement which is robust against external disturbances such as magnetic fields.

In order to achieve the above-mentioned demand, the present invention uses a shunt resistor for current sensing. If the current flows through such a shunt resistor, a voltage drop over the terminals of the shunt resistor usually is proportional to the current which flows through the shunt resistor. Thus, the current through the shunt resistor can easily be determined based on the voltage drop over the shunt resistor.

The shunt resistor may be any kind of resistor which is appropriate for current sensing purposes. For example, the shunt resistor may be realised based on an appropriate conductive material such as a metal or alloy like copper - nickel - manganese alloy or nickel - chromium alloys. For example, the shunt resistor may be realised based on material having a small thermal coefficient. Usually, shunt resistors have a rather small resistance, especially resistance lower than 1 Ohm, in particular a resistance in the range of 0,025 up to 0,1 Milliohms. In this way, the power loss through the shunt resistor is low.

When analysing the inventive concept of using a shunt resistor for current measuring in a load-break switching device, it has been found to be advantageous that the shunt resistor could be located close to the busbar system. In other words, the shunt resistor should be preferably located between the load-break unit and the first connector unit, especially the nearby or even within the first connector unit of the load-break switching device. In this way, it is possible to achieve a very compact, small-sized and robust configuration for current measuring in the load-break switching device.

In a possible embodiment of the load-break switching device, the fuse units may be adapted to receive a fuse in the range of NH000 to NH03 or an equivalent type of rated current. Accordingly, the concept according to the present invention makes it possible to realise compact and small-sized load-break switching devices, comprising fuses with a relatively high rated current. For example, the load-break switching device may comprise a fuse with a maximum rated voltage up to 1000 Volts. The fuses may be, for example, any appropriate fuse according to the UL or IEC domain. The fuses may be NH fuses (NH000 up to NH3), UL fuses (class CC, class J class CF, etc.) or cylindrical fuses such as D0, D01, D02, 22x58 10x85, 14x51, or the like. However, any other appropriate fuse with a same or at least almost similar rated current may be possible, too. The fuses may have a cylindrical shape which fits to the compartment of the fuse receiving element.

Thus, the proposed concept for current measuring can be used even in switch disconnectors with small assembly volume. Further, the proposed concept can be realised by a simple element such as the shunt resistor which causes low-cost, and which can perform a very robust and reliable current measuring.

The busbar system to which the load-break switching device is connected may comprise one or more busbars. For example, in case of an AC application with a single phase, the busbar system may comprise only a single busbar. Alternatively, for applications with multiple phases, the busbar system may comprise more than one busbar. For example, the busbar system may comprise three busbars (L1, L2, L3) for a three-phased AC system. However, the busbar system may be also a busbar system for a DC application. In this case, the busbar system may comprise, for example, two busbars (a positive busbar and negative busbar). However, the present invention is not limited to the above-mentioned examples. Moreover, any other number of busbars may be possible, too.

The load-break switch switching device may be electrically coupled with the busbars of the busbar system by a first connector unit. For this purpose, a separate connection element (first terminal) may be provided in the first connector unit for each busbar to be connected. The connection elements may be configured in such a manner that a reliable electrical connection can be established when connecting the terminals of the first connector unit to the busbars of the busbar system. For example, the first terminals may comprise springs or the like in order to provide an appropriate force towards the busbars. However, any other appropriate measure for a reliable electrical connection may be possible, too.

For each first terminal of the first connector unit, a corresponding second terminal of the second connector unit may be provided. For example, an electrical device such as a load, in particular a motor or the like, may be electrically connected to the second connector unit of the load-break switching device. For this purpose, wires may be connected to the second terminals of the second connector unit by means of clamp connections or screw connections. The electrical connection at the second connector unit can be established in any other way, too.

The load-break unit of the load-break switching device is electrically arranged between the first connector unit and the second connector unit. In this way, the load-break unit can establish an electrical connection between the first terminals of the first connector unit and the corresponding second terminals, if the respective switching elements of the load-break unit are closed. Alternatively, the electrical connection between the first terminals and the corresponding second terminals is interrupted, if the respective switching elements of the load-break unit are opened. In particular, the load-break unit can even interrupt the electrical connection if a current is flowing through the load-break unit.

In a possible embodiment, the fuse units may be adapted to receive cylindrical fuses, in particular fuses such as D0, D01, D02, 22x58 10x85, 14x51, or the like.

In a possible embodiment, the load-break switching device comprises a monitoring unit. The monitoring unit is adapted to determine at least one current in the current path between one of the first terminals of the first connector unit and the load-break unit based on a voltage drop over the shunt resistor in the respective current path. For example, the monitoring unit may comprise a voltage measurement unit for measuring the voltage drop over the shunt resistor and a processing unit for determining the current through the shunt resistor based on the measured voltage drop. Since the current usually is proportional to the voltage drop, the current may be easily calculated by dividing the voltage drop by the resistance of the shunt resistor. For this purpose, the resistance of the shunt resistor may be determined in advance. However, any other schema for determining a factor specifying the relationship between the voltage drop and the resulting current may be possible, too.

In a possible embodiment, the monitoring unit is adapted to measure a voltage at a connection point between one of the first terminals of the first connector unit and the load-break unit. In this case, the monitoring unit may be a further adapted to determine a power flow and/or a current direction based on the sensed currents and measured voltages. In case of alternating currents, the monitoring unit may consider a phase shift between the determined currents and voltages. Accordingly, the direction of the current/power flow and/or active power / reactive power can be determined.

In a possible embodiment, the monitoring unit comprises a communication interface. The communication interface may be adapted to establish a communication link, in particular a communication link with a remote device. The communication interface may be further configured to output data for specifying the determined current values. The communication interface may be, for example, a communication interface such as Modbus/RTU, Modbus/TCP/IP, CAN-bus, IO-Link or any other appropriate communication standard. The communication interface may also use, for example, power LAN technologies, such as power line. In this way, the communication can be performed, for example via the powerlines connected to the first connector unit and/or the second connector unit, or via a (DC) power supply of the monitoring unit and/or other auxiliary devices of the load-break switching device. Additionally or alternatively, it may be also possible to perform a wireless communication. For example, the communication interface may use WLAN, Bluetooth, NFC, Zigbee or any other known or upcoming communication standard.

In a possible embodiment, the monitoring unit is adapted to trigger the load-break unit. In particular, the monitoring unit may be adapted to trigger the load-break unit for interrupting the electrical connections between the first terminals of the first connector unit and the corresponding second terminals of the second connector unit. The connections may be interrupted if at least one determined current exceeds a predetermined threshold value. In this way, an overcurrent protection based on the sensed current values can be realised.

In a possible embodiment, each terminal of the first connector unit comprises a connection element adapted to connect the respective first terminal to a related busbar of the busbar system. In this case, the shunt resistors in the current paths between the first terminals of the first connector unit and the load-break unit may be directly connected to the connection elements of the first connector unit, respectively. Alternatively, the shunt resistors may be even integrated in the first connector unit. Accordingly, the shunt resistors can be arranged very close to the connection of the busbars.

In a possible embodiment, each fuse in a fuse unit has a maximum rated current of at least 160 Ampere. In particular the maximum rated current may be even at least 250 Ampere, 355 Ampere, 500 Ampere or at least 800 Ampere. Such maximum rated currents can be achieved, for example, using the NH fuses mentioned above or similar fuses having a respective rated current..

In a possible embodiment, the load-break unit is arranged in a current path between the first connector unit and the fuse unit. Additionally or alternatively, a load-break unit may be arranged in a current path between the fuse unit and the second connector unit. Thus by using two load break-units in each current path, both terminals of the fuse unit can be electrically separated by one of the two load-break unit. The two load-break units may be switched synchronously, i.e. both load-break unit may be opened and closed at the same time. Alternatively, the two load-break unit may be switched individually.

In a possible embodiment, the load-break switching device comprises a sensor element. The sensor element may be adapted to sense a physical property of the shunt resistor. For example, the sensor element may sense a temperature close to the shunt resistor. Accordingly, the monitoring unit may be adapted to determine the current in the current path between one of the first terminals of the first connector unit and the load-break unit based on the physical property sensed by the sensor element. For example, the determined current value may be compensated based on the sensed physical properties, e.g. a temperature compensation of the resistance of the shunt resistor may be applied. In this case, the sensor element may comprise a thermal sensor.

In a possible embodiment, the monitoring unit is configured to output an alarm signalling. In particular, the alarm signalling may be output if at least one of the determined currents exceeds a predetermined threshold value. The signalling may be an optical, acoustic and/or haptic signalling. Additionally or alternatively, an electrical signal may be provided. For example, the signalling may be forwarded to a further device, in particular a remote device. It is way, a user can be informed about an upcoming issue such as a current which is currently close to a limit.

In a possible embodiment, the load-break unit is adapted to interrupt electrical connections between the first terminals of the first connector unit and the corresponding second terminals of the second connector unit on load. In other words, the load-break unit can interrupt the electrical connection between the first terminals of the first connector unit and the related second terminals of the second connector unit even if a current is flowing through the load-break unit. This makes it possible, for example, to switch even loads with high inductance or capacitance such as, for example, electrical motors. In particular, the load-break switch may switch loads up to AC-23B according to IEC 60947-3.

In a possible embodiment, the load-break switch device has an outer width of at most 27 millimetres, in particular at most 22,5 millimetres.Accordingly, the load-break switching device is realised with a very small size and assembly volume. In particular, the load-break switching devices with such dimensions as appropriate to provide the required distances with respect to the leakage current demands as required, for example according to the pending UL norms. In this context, width is considered as the extent between the two side faces. These sides are usually run parallel to each other. The width can refer to a grid size or similar feature of the load-bread switching assembly. In particular, the width can be the smallest extent of the assembly in one of the spatial directions.

In the following, possible embodiments of the different aspects of the present invention are described in more detail with reference to the enclosed figures.
- Fig. 1:: a schematic diagram of load-break switching device according to an embodiment;
- Fig. 2:: a schematic diagram of a monitoring unit for a load-break switching device according to an embodiment;
- Fig. 3:: a schematic diagram of a monitoring unit for a load-break switching device according to another embodiment;
- Fig. 4:: a schematic illustration of a load-break switching device in a switching cabinet arrangement according to an embodiment; and
- Fig. 5:: a flow diagram illustrating a method for operating a load-break switching device according to an embodiment.

### Description of embodiments

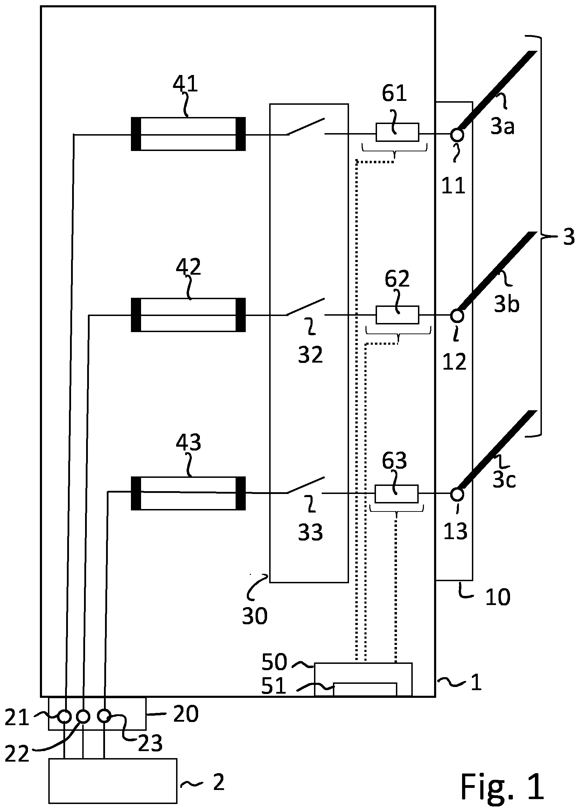

Figure 1 shows a schematic block diagram illustrating a load-break switching device 1 according to an embodiment. The load-break switching device 1 may comprise a first connector unit 10, a second connector unit 20 and a load-break unit 30.

The load-break switching device 1 may be electrically (and mechanically) connected to a busbar system 3. For this purpose, the first connector unit 10 may comprise one or more first terminals 11, 12, 13. Each first collection terminal 11, 12, 13 may be connected to a respective busbar 3a, 3b, 3c of the busbar system 3. For this purpose, the first terminals 11, 12, 13 may comprise appropriate connection elements for a reliable connection with the corresponding busbar 3a, 3b, 3c. For example, the first terminals 11, 12, 13 may have a shape which fits to corresponding elements of the busbars 3a, 3b, 3c.

Even though the present invention is described here and in the following embodiments in connection with a busbar system 3 comprising three busbars 3a, 3b, 3c, the present invention is not limited to a busbar system comprising three busbars. Moreover, any other appropriate number of busbars, in particular one busbar, two busbars or more than three busbars may be possible, too. For example, the present invention may be also applicable to AC applications with only a single phase requiring only a single busbar. Furthermore, it may be also possible to apply the present invention to DC applications.

In another configuration, the load-break switching device 1 may be connected at the first connector unit 10 in any other way instead of using a busbar system 3. For example, the load-break switching device 1 may be directly mounted on a on a mounting plate or a top-hat rail. In such a configuration, the first terminals 11, 12, 13 of the first connector unit 10 may be coupled with corresponding wires 3a, 3b, 3c of an electrical system 3.

The second connector unit 20 may comprise one or more second terminals 21, 22, 23. In particular, the number of second terminals corresponds to the number of first terminals 11, 12, 13. Each second terminal 21, 22, 23 may be connected to an external electrical device 2. For this purpose, each second terminal 21, 22, 23 may receive a wire for connecting the respective second terminal 21, 22, 23 with the external electrical device 2. For example, the second terminals 21, 22, 23 may comprise a clamping mechanism or any other appropriate component for receiving and fastening the wires. In this way, it is possible to electrically connect the busbars 3a, 3b, 3c via the internal structure of the load-break switching device 1 with the external electrical device 2.

The external electrical devices 2 may be any kind of appropriate electrical device. For example, the electrical device 2 may be an electrical load, e.g., a motor, an actor of an automation system or any other component requiring electrical power. However, the external electrical device 2 may be also a power source, e.g., an inverter of a photovoltaic system or any other device providing electrical power. In this way, electrical power of the external electrical device 2 may be provided to the busbar system 3.

The load-break switch device 1 comprises a load-break unit 30 which can establish or interrupt the electrical connection between the first terminals 11, 12, 13 and the corresponding second terminals 21, 22, 23. For this purpose, load-break unit 30 may comprise a number of switching element 31, 32, 33. In particular, a separate switching element 31, 32, 33 is provided for each current path between a first terminal 11, 12, 13 and the corresponding second terminal 21, 22, 23. The operation of the individual switching elements 31, 32, 33 may be controlled by a common, single mechanism. Accordingly, the switching elements 31, 32, 33 are all either in a closed state or in an open state. The switching elements 31, 32, 33 may be switching elements which can interrupt the connection between the first connecting terminals 11, 12, 13 and the second connecting terminals 21, 22, 23 even if a current is flowing through the switching element 31, 32, 33. In other words, the switching element 31, 32, 33 can be opened on load.

The load-break switching device 1 further comprises a shunt resistor 61, 62, 63 in each current path between the first terminal 11, 12, 13 of the first connector unit 10 and the related switching element 31, 32, 33 of the load-break unit 30. In other words, the shunt resistor 61, 62, 63 are arranged close to busbars 3a, 3b, 3c of the busbar system 3. In particular, the shunt resistors 61, 62, 63 are arranged close to or even within the first connector unit 10.

The shunt resistors 61, 62, 63 may have a relatively low resistance. In particular, the resistance of the shunt resistors 61, 62, 63 may be less than 1 Ohm. Preferably, the resistance of the shunt resistors 61, 62, 63 may be in the range of between 0,025 up to 0,1 Milliohms. The shunt resistors 61, 62, 63 may comprise a resistive component such as a metal or alloy. Preferably, the shunt resistors 61, 62, 63 may have a resistive element with a small thermal coefficient.

The shunt resistors 61, 62, 63 may comprise a cooling element for dissipating the power loss of the respective shunt resistors 61, 62, 63. Additionally or alternatively, the shunt resistors 61, 62, 63 may have an appropriate mechanical structure or shape which supports the thermal dissipation of the shunt resistors 61, 62, 63.

In such a configuration with a shunt resistor 61, 62, 63 in each current path between a first terminal 11, 12, 13 of the first connector unit 10 and a related a second terminal 21, 22, 23 of the second connector unit 20, a current in the current path causes a voltage drop over the respective shunt resistor 61, 62, 63. This voltage drop is almost proportional to the resistance of the respective shunt resistor 61, 62, 63. Thus, a value of the current in the respective current path can be easily determined based on the voltage drop over the shunt resistor 61, 62, 63 and the value of the resistance of the shunt resistor 61, 62, 63.

In order to determine the current through the shunt resistors 61, 62, 63, a monitoring unit 50 is provided in the load-break switching device 1. The monitoring unit 50 may measure the voltage drop over the shunt resistors 61, 62, 63 and determine the corresponding current value. For this purpose, appropriate data such as the values of the respective shunt resistors 61, 62, 63 may be stored in the monitoring unit 50.

The resulting values of the determined currents through the shunt resistors 61, 62, 63 may be further used for any appropriate measures. For example, the determined current values may be used in order to trigger load-break unit 30. For instance, the switch element 31, 32, 33 of the switching unit 30 may be opened if at least one of the determined current values through a shunt resistor 61, 62, 63 exceeds a predetermined threshold. In this way, an overcurrent protection can be realized.

Additionally or alternatively, monitoring unit 50 may comprise a communication interface 51. Accordingly, this communication interface 51 may transmit data to a remote device and/or receive data from a remote device. The communication between communication interface 51 of monitoring unit 50 and the remote device may be performed, for example, based on any appropriate communication standard, for example Modbus RTP, Modbus TCP/IP, CAN bus, IO link, etc. However, any other standard or proprietary communication schema may be used, too. The communication of the communication interface 51 may also use, for example, power LAN technologies, such as power line. Thus, the communication may be performed, for example via the powerlines connected to the first connector unit 10 and/or the second connector unit 20, or via a (DC) power supply of the monitoring unit 50 and/or other auxiliary devices of the load-break switching device 1. Additionally or alternatively, it may be also possible to perform a wireless communication. For example, the communication interface 51 may use WLAN, Bluetooth, NFC, Zigbee or any other known or upcoming communication standard.

Monitoring unit 50 may further measure voltages at a terminal of the shunt resistors 61, 62, 63. The voltage may be measured, for example, at the terminal of the shunt resistor 61, 62, 63 facing towards the first connector unit 10 or a terminal of the shunt resistor 61, 62, 63 facing towards the load-break unit 30. Based on the measured voltage, monitoring unit 50 may further determine a direction of the current flowing through shunt resistors 61, 62, 63. Additionally or alternatively, monitoring unit 50 may determine a power flow through the respective shunt resistor 61, 62, 63 taking into account the determined current value and the related voltage value. In case of alternating current (AC) applications, monitoring unit 50 may consider a phase shift between current and voltage. Based on this phase shift, active power and reactive power may be determined. Further to this, monitoring unit 50 may also determine any other appropriate values which can be determined based on the acquired current and voltage values.

Further, a fuse unit 41, 42, 43 may be arranged in each current path between the first terminals 11, 12, 13 and the second terminals 21, 22, 23. In particular, the fuse units 41, 42, 43 are arranged between the switching elements 31, 32, 33 of the load-break unit 30 and the second terminals 21, 22, 23 of the second connector unit 20. However, the fuse units 41, 42, 43 may be also arranged at different positions in the current paths between the first connector unit 10 and the second connector unit 20. The fuses may be, for example, any appropriate fuse according to the UL or IEC domain. The fuses may be NH fuses (NH000 up to NH3), UL fuses (class CC, class J class CF, etc.) or cylindrical fuses such as D0, D01, D02, 22x58 10x85, 14x51, or the like. Accordingly, the fuses can be specified for voltages of up to 1000 volts, for example. The fuses can be rated up to 160A, 250A, 355A, 500A or up to 800A. From these specifications, the required dimensions for the appropriate fuses can be derived.

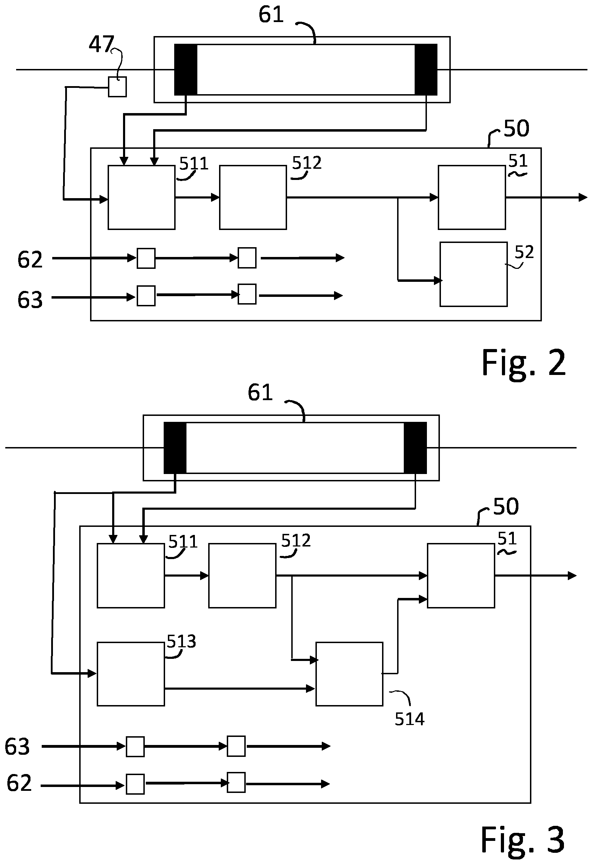

Figure 2 shows a schematic illustration of monitoring unit 50 according to an embodiment. To simplify the illustration, only the components in connection with a single shunt resistor 61 are illustrated in detail. However, the explanation also applies for the elements in connection with the other shunt resistors 62 and 63.

Monitoring unit 50 comprises a first measurement element 511 for measuring the voltage drop over shunt resistor 61. The measured voltage drop may be provided to an analysis element 512. Analysis element 512 may determine the current through the shunt resistor 61 based on the measured voltage drop over shunt resistor 61. In particular, the current through shunt resistor 61 may be calculated by dividing the voltage drop over shunt resistor 61 through the resistance of shunt resistors 61. For this purpose, the resistance of shunt resistor 61 or any other appropriate parameter specifying the relationship between the voltage drop and the resulting current may be stored, for example, in the analysis element 512. This relationship between the voltage drop and the resulting current may be determined in advance.

The determined current through shunt resistor 61 may be provided, for example, to communication interface 51 and/or a control unit 52. For example, control unit 52 may perform control operations based on the determined current value through shunt resistor 61. For instance, control unit 52 may trigger load-break unit 32 to open switching elements 31, 32, 33 if at least one current through a shunt resistor 61, 62, 63 exceeds a predetermined threshold.

As further illustrated in the exemplary embodiment according to figure 2, monitoring unit 50 may receive a further sensing signal from a sensing element 47. For example, such a sensing element 47 may be arranged close to a shunt resistor 61, 62, 63. In this way, sensing element 47 may sense a physical property of shunt resistor 61, 62, 63. For example, sensing element 47 may be a thermal sensor. Accordingly, a temperature of the shunt resistor 61, 62, 63 may be sensed by the respective sensing element 47. In such a case, the determined temperature of the shunt resistors 61, 62, 63 may be further taken into account when determining the current through the respective shunt resistor 61, 62, 63. For example, a thermal compensation may be performed taking into account the thermal coefficient of the resistance of shunt resistor 61, 62, 63. Accordingly, such a thermal compensation may further increase the accuracy of the determined current through shunt resistor 61, 62, 63.

Figure 3 shows a schematic illustration of a monitoring unit 50 according to a further embodiment. Since the configuration of monitoring unit 50 mainly is based on the configuration of monitoring unit 50 of the previously described embodiments according to figure 1 and figure 2, the above provided explanations also apply to the embodiment of figure 3. Furthermore, the additional features according to figure 3 may be also applied to the above-described embodiments.

The monitoring unit 50 according to figure 3 further comprises a second measurement element 513. This second measurement element 513 may measure a voltage at a terminal of shunt resistor 61. The voltage may be measured at the terminal facing towards the first connector unit 10 or the terminal facing towards the load-break unit 30. Monitoring unit 50 may further comprise a computing unit 514. This computing unit 514 may receive the determined current value through shunt resistor 61 and the related voltage at a terminal of shunt resistor 61. Based on the respective current and voltage, computing unit 514 may calculate a power flow through shunt resistor 61. The case of an alternating current applications, computing unit 514 may determine a phase shift between the voltage and the current. Based on this phase shift, active and/or reactive power may be calculated. Furthermore, a direction of the power flowing through the shunt resistor 61 may be determined.

As already mentioned in connection with figure 2, the above-described elements in connection with shunt resistor 61 are also applicable to the further shunt resistors 62 and 63.

In the above examples, the fuse units 41, 42, 43 are provided between the load-break unit 30 and the second connection unit 20, whereas the load-break unit 30 is connected to the first connection unit 10. In general, however, other configurations are possible in which the fuse units 41, 42, 43 are connected to the first connection unit 10 and the load-break unit 30 is connected to the second connection unit 20. In this case, the above explanations apply accordingly, whereby the skilled person will make appropriate configuration adjustments where necessary.

In a further alternative embodiment, the load-break switching device 1 may comprise two load-break units 30. In such a configuration, a first load-break unit 30 may be arranged between the first connection unit 10 and the fuse units 41, 42, 43. A further, second load-break unit 30 may be arranged between the fuse units 41, 42, 43 and the second connection unit 20. For example, the first and the second load-break unit 30 may be switched synchronously, i.e. both load-break unit 30 are switched on or off at the same time. However, it may be also possible to switch the first load-break unit 30 and the second load-break unit 30 independently from each other.

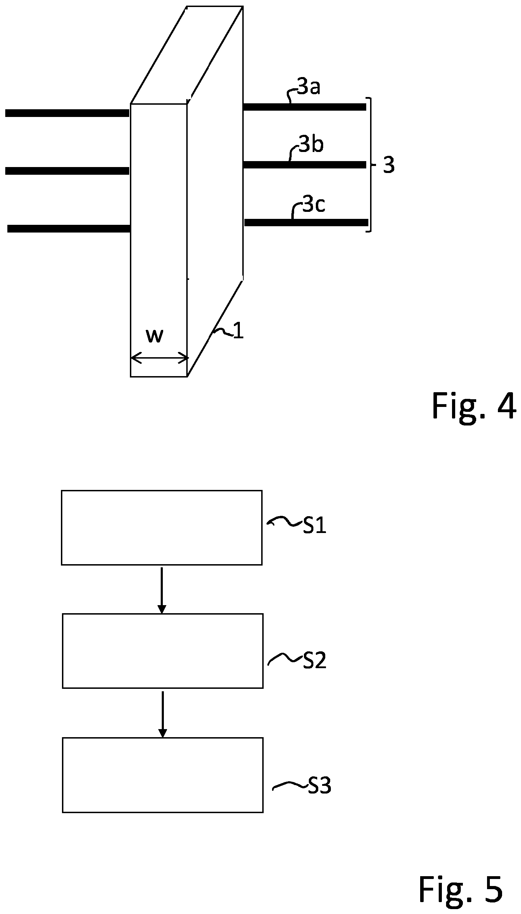

The load-break switching device 1 may be installed, for example, in a switching cabinet with a busbar system 3. Such a configuration is illustrated, for example, in figure 4. For instance, such a configuration may be used in an automation system. In particular, the load-break switching device 1 may be used for supplying power to a load 2. The load 2 connected to the load-break switching device 1 may be, for example, a resistive, inductive or capacitive load. For instance, load to may be an electrical motor or the like. However, any other load, such as an actor of an automation system or the like may be possible, too.

As can be further seen in figure 4, load-break switching device 1 may comprise a housing including the above-described components. In particular, the housing of load-break switching device 1 may have a relatively small width w. For example, width w of the housing may be 27 mm) or less. In particular, width w of the housing may be only 22,5. This makes it possible to realize small-sized devices and fulfil the requirements for the required distances with respect to the leakage current demands as required, for example according to the pending UL norms or other standards. However, depending on the further constraints of the application, any other dimensions may be possible, too.

Figure 5 shows a flow diagram illustrating a method for operating a load-break switching device 1 according to an embodiment. The method may be applied to the above-described load-break switching device 1. Hence, the method may comprise any step for performing operations as already described above in connection with the load-break switching device 1. Further, the above-described load-break switching device 1 may comprise any kind of device, unit or component for performing operations as described in the following in connection with the method.

The method comprises a step S1 of measuring a voltage drop over the shunt resistor 61, 62, 63 in the current path between one of the first terminals 11, 12, 13 of the first connector unit 10 and the load-break unit 30.

The method further comprises a step S2 of determining a current in the respective current path between one of the first terminals 11, 12, 13 of the first connector unit 10 and the load-break unit 30. In particular, the respective current may be determined based on the measured voltage drop over the shunt resistor 61, 62, 63.

Further, the method comprises a step S3 of providing an output signal indicating the determined current. The output signal may be provided, for example by means of an appropriate communication interface 51. In particular, the output signal may be provided via a wired and/or wireless connection to a remote device. Additionally or alternatively, the output signal may be used internally in the load-break switching device 1. For example, a switching operation of a load-break unit 30 may be triggered based on the determined current values.

Summarising, the present invention relates to a low-width load-break switching device for a busbar system. The load-break switching device comprises shunt resistors which are arranged close to the connections to the busbar system. A voltage drop over the shunt resistors is analysed to determine a current value flowing through the load-break switching device.

## Claims

1. Load-break switching device (1) for a busbar system (3), comprising:
a first connector unit (10) comprising at least one first terminal (11, 12, 13), each first terminal (11, 12, 13) being adapted to be connected to a power source or load (3);
a second connector unit (20) comprising at least one second terminal (21, 22, 23), each second terminal (21, 22, 23) being adapted to connect to an electrical connection of an external electrical device (2) ;
a load-break unit (30), adapted to interrupt electrical connections between the first terminals (11, 12, 13) of the first connector unit (10) and the corresponding second terminals (21, 22, 23) of the second connector unit (20);
a shunt resistor (61, 62, 63) in each current path between one of the first terminals (11, 12, 13) of the first connector unit (10) and the load-break unit (30), respectively; and
at least one fuse unit (41, 42, 43), each of the at least one fuse unit (41, 42, 43) being disposed in a current path between a first terminal (11, 12, 13) of the first connector unit (10) and a corresponding second terminal (21, 22, 23) of the second connector unit (20).

2. Load-break switching device (1) according to claim 1, wherein each fuse unit (41, 42, 43) is adapted to receive a fuse in the range of NH000 to NH03 or an equivalent type of rated current, in particular, wherein each fuse unit (41, 42, 43) is adapted to receive a cylindrical fuse.

3. Load-break switching device (1) according to claim 1 or 2, comprising a monitoring unit (50) adapted to determine a current in the current path between one of the first terminals (11, 12, 13) of the first connector unit (10) and the load-break unit (30) based on a voltage drop across the shunt resistor (61, 62, 63) in the respective current path.

4. Load-break switching device (1) according to claim 3, wherein the monitoring unit (50) is adapted to measure a voltage at a connection between one of the first terminals (11, 12, 13) of the first connector unit (10) and the load-break unit (30), and to determine power flow and/or current direction based on the sensed current and measured voltage.

5. Load-break switching device (1) according to claim 3 or 4, wherein the monitoring unit (50) comprises a communication interface (51) adapted to establish a communication link with a remote device, and to output data comprising the sensed current.

6. Load-break switching device (1) according to any of claims 3 to 5, wherein the monitoring unit (50) is adapted to trigger the load-break unit (30) to interrupt electrical connections between the first terminals (11, 12, 13) of the first connector unit (10) and the corresponding second terminals (21, 22, 23) of the second connector unit (20) if at least one determined current exceeds a predetermined threshold value.

7. Load-break switching device (1) according to any of claims 3 to 6, wherein each terminal (11, 12, 13) of the first connector unit (10) comprises a connection element adapted to connect the respective first terminal (11, 12, 13) to a related terminal of the power source or load (3), and
wherein the shunt resistors (61, 62, 63) in the current paths between the first terminals (11, 12, 13) of the first connector unit (10) and the load-break unit (30) are directly connected to the connection elements, respectively.

8. Load-break switching device (1) according to any of claims 3 to 7, comprising a sensor element (47) adapted to sense a physical property of the shunt resistor, and wherein the monitoring unit (50) is adapted to determine the current in the current path between one of the first terminals (11, 12, 13) of the first connector unit (10) and the load-break unit (30) based on the physical property sensed by the sensor element (47).

9. Load-break switching device (1) according to claim 8, wherein the sensor element (47) comprises a thermal sensor.

10. Load-break switching device (1) according to any of claims 3 to 9, wherein the monitoring unit (50) is configured to output an alarm signal if at least one of the determined currents exceeds a predetermined threshold value.

11. Load-break switching device (1) according to any of claims 1 to 10, wherein the load-break unit (30) is adapted to interrupt electrical connections between the first terminals (11, 12, 13) of the first connector unit (10) and the corresponding second terminals (21, 22, 23) of the second connector unit (20) under load.

12. Load-break switching device (1) according to any of claims 1 to 11, wherein each fuse in the at least one fuse unit (41, 42, 43) has a maximum rated current of at least 160 Ampere, in particular at least 250 Ampere, 355 Ampere, 500 Ampere or 800 Ampere.

13. Load-break switching device (1) according to any of claims 1 to 12, wherein the load-break switching device (1) has an outer width of at most 27 millimetres, in particular at most 22,5 millimetres.

14. Switching cabinet arrangement, comprising:
a load-break switching device (1) according to any of claims 1 to 13; and
a busbar system (3) comprising at least one busbar (3a, 3b, 3c),
wherein the at least one busbar (3a, 3b, 3c) is electrically connected to the first connector unit (10) of the load-break switching device (1).

15. Automation system, comprising:
a load-break switching device (1) according to any of claims 1 to 13; and
a busbar system (3) comprising at least one busbar (3a, 3b, 3c),
wherein the at least one busbar (3a, 3b, 3c) is electrically connected to the first connector unit (10) of the load-break switching device (1); and
an electric device (2), electrically connected to the second connector unit (20) of the load-break switching device (1).

16. Method for operating a load-break switching device (1) according to any of claims 1 to 13, comprising the steps of:
measuring (S1) a voltage drop over the shunt resistor (61, 62, 63) in the current path between one of the first terminals (11, 12, 13) of the first connector unit (10) and the load-break unit (30);
determining (S2) a current in the respective current path between one of the first terminals (11, 12, 13) of the first connector unit (10) and the load-break unit (30) based on the measured voltage drop across the shunt resistor (61, 62, 63); and
providing (S3) an output signal indicating the determined current.
